# EUROPEAN PATENT APPLICATION

(11) **EP 4 822 746 A1**
(43) Date of publication of application: **14.10.2026**
(21) Application number: 24906404.9
(22) Date of filing: 18.12.2024
(51) Int. Cl.: H01L 23/495

(54) **PACKAGE STRUCTURE AND POWER CONVERSION DEVICE**

(30) Priority: 22.12.2023 CN 202311779185
(71) Applicant: Huawei Technologies Co., Ltd., Shenzhen, Guangdong 518129 (CN)
(72) Inventor: WANG, Zeyu, Shenzhen, Guangdong 518129 (CN); WANG, Jun, Shenzhen, Guangdong 518129 (CN); WANG, Yuru, Shenzhen, Guangdong 518129 (CN); YANG, Heli, Shenzhen, Guangdong 518129 (CN); YU, Bo, Shenzhen, Guangdong 518129 (CN)
(74) Representative: Körber, Martin Hans
(86) International application number: PCT/CN2024/140316
(87) International publication number: WO 2025/130925

(57) **Abstract**

This application provides a packaging structure and a power conversion apparatus. The packaging structure includes a lead frame, a first diode chip, a second diode chip, a first bonding member, and a plastic packaging body. The first diode chip and the second diode chip both have a first electrode and a second electrode. The first electrode of the first diode chip and the first electrode of the second diode chip are both soldered to a surface of the lead frame. An electrical connection between the first electrodes of the first diode chip and the second diode chip is implemented through the lead frame. The second electrode of the first diode chip is bonded to the second electrode of the second diode chip through the first bonding member. The plastic packaging body wraps the first diode chip, the second diode chip, and the first bonding member. **In** this application, parasitic inductance between the second electrodes of the first diode chip and the second diode chip is reduced, thereby suppressing an amplitude of voltage oscillation between the second electrodes of the first diode chip and the second diode chip, and eliminating electromagnetic compatibility oscillation.

## Description

### CROSS-REFERENCE TO RELATED APPLICATIONS

This application claims priority to Chinese Patent Application No. 202311779185.6, filed with the China National Intellectual Property Administration on December 22, 2023 and entitled "PACKAGING STRUCTURE AND POWER CONVERSION APPARATUS", which is incorporated herein by reference in its entirety.

### TECHNICAL FIELD

This application relates to the field of power conversion technologies, and in particular, to a packaging structure and a power conversion apparatus.

### BACKGROUND

A common cathode diode is a device commonly used in a power conversion apparatus, and usually the common cathode diode is electrically connected to a switch device. In an operating process of the power conversion apparatus, the switch device is frequently turned on and off. This causes potentials at two ends of the common cathode diode to jump, resulting in electromagnetic compatibility (electromagnetic compatibility, EMC) oscillation.

### SUMMARY

Embodiments of this application provide a packaging structure and a power conversion apparatus, to eliminate electromagnetic compatibility oscillation of the packaging structure.

According to a first aspect, an embodiment of this application provides a packaging structure. The packaging structure provided in this embodiment of this application may include: a lead frame, a first diode chip, a second diode chip, a first bonding member, and a plastic packaging body. The first diode chip and the second diode chip are both located on the lead frame. The first diode chip and the second diode chip both have a first electrode and a second electrode. In this embodiment of this application, the first electrode is an anode of the diode chip, and the second electrode is a cathode of the diode chip; or the first electrode is a cathode of the diode chip, and the second electrode is an anode of the diode chip. The first electrode of the first diode chip and the first electrode of the second diode chip are both soldered to a surface of the lead frame. The lead frame includes an electrically conductive material. For example, the lead frame may include a metal material such as copper, iron, or aluminum. The first electrode of the first diode chip is electrically connected to the first electrode of the second diode chip through the lead frame. The second electrode of the first diode chip is bonded to the second electrode of the second diode chip through the first bonding member. The plastic packaging body wraps the first diode chip, the second diode chip, and the first bonding member.

In the packaging structure provided in this embodiment of this application, the first electrode of the first diode chip is electrically connected to the first electrode of the second diode chip through the lead frame, and the first electrode may be a cathode or an anode of a diode. Therefore, the packaging structure provided in this embodiment of this application may be a common cathode diode packaging structure, or may be a common anode diode packaging structure. In this embodiment of this application, the first bonding member is disposed in the packaging structure, so that the second electrode of the first diode chip may be bonded to the second electrode of the second diode chip through the first bonding member. In this way, parasitic inductance between the second electrodes of the first diode chip and the second diode chip can be reduced, thereby suppressing an amplitude of voltage oscillation between the second electrodes of the first diode chip and the second diode chip, and eliminating electromagnetic compatibility oscillation. In addition, the second electrode of the first diode chip is bonded to the second electrode of the second diode chip through the first bonding member. This does not affect a connection relationship between the first diode chip or the second diode chip and another component, and does not affect overall performance of the packaging structure.

In addition, the plastic packaging body wraps the first diode chip, the second diode chip, and the first bonding member, and the packaging body may play a function of protecting and fastening various components. The first bonding member is packaged inside the plastic packaging body, so that the first bonding member is not exposed outside the packaging structure, and no electrical safety or reliability problem is caused, thereby ensuring high security and reliability of the packaging structure. The first bonding member in this embodiment of this application may be a bonding wire, a strip structure, a sheet structure, or the like. For example, the strip structure may be an aluminum ribbon (ribbon), and the sheet structure may be a copper clip (clip). For example, the first bonding member may include a metal material such as copper, aluminum, gold, or silver, or the first bonding member may include another electrically conductive material. In a manufacturing process, the first bonding member may be manufactured by using a bonding process or another process, which is easily compatible with a manufacturing process of another component in the packaging structure. For example, the first bonding wire may be manufactured in a wire bonding (wire bonding) process of a packaging front-of-line (front-of-line, FOL) process. The manufacturing process is feasible and stable, with low manufacturing costs, high manufacturability, and high supply availability.

In this embodiment of this application, the first diode chip and the second diode chip are disposed in the packaging structure, and the first diode chip and the second diode chip are disposed in parallel. In other words, two diode chips in parallel are disposed in the packaging structure. During specific implementation, more diode chips in parallel may be disposed in the packaging structure. Alternatively, another electronic component may be disposed in the packaging structure according to an actual requirement. The packaging structure in this embodiment of this application may use a transistor outline (transistor outline, TO), or the packaging structure may be in another packaging form.

In this embodiment of this application, the first electrode of the first diode chip may be located on a lower surface of the first diode chip, the second electrode of the first diode chip may be located on an upper surface of the first diode chip, the first electrode of the second diode chip may be located on a lower surface of the second diode chip, and the second electrode of the second diode chip may be located on an upper surface of the second diode chip. The upper surface of the first diode chip (or the second diode chip) is a surface on a side that is of the first diode chip (or the second diode chip) and that faces away from the lead frame, and the lower surface is a surface on a side that is of the first diode chip (or the second diode chip) and that is close to the lead frame. In this embodiment of this application, the first electrode and the second electrode of the first diode chip (or the second diode chip) are disposed on the lower surface and the upper surface respectively, to facilitate an electrical connection to another component. In addition, the first electrodes of the first diode chip and the second diode chip are located on surfaces on a same side, and the second electrodes are located on surfaces on a same side, to facilitate an electrical connection between the first electrodes of the first diode chip and the second diode chip and an electrical connection between the second electrodes of the first diode chip and the second diode chip. Because the lead frame in this embodiment of this application includes the electrically conductive material, when the first diode chip and the second diode chip are installed at corresponding positions on the surface of the lead frame, an electrical connection between the first electrodes of the first diode chip and the second diode chip can be implemented. The first bonding member is lapped to the upper surfaces of the first diode chip and the second diode chip, so that an electrical connection between the second electrodes of the first diode chip and the second diode chip can be implemented through the first bonding member.

Certainly, in some cases, the first electrode and the second electrode of the first diode chip (or the second diode chip) may alternatively be disposed on a surface on a same side. For example, the first electrode and the second electrode of the first diode chip (or the second diode chip) may be disposed at different positions on the upper surface, and can also implement an electrical connection to another component, and may be disposed based on a spatial layout of the packaging structure.

In some embodiments of this application, the second electrodes of the first diode chip and the second diode chip may be electrically connected to different pins respectively. The lead frame may include: a substrate, a first pin, and a second pin that are disposed separately. The first diode chip and the second diode chip are located on the substrate, and the substrate may perform functions such as support and heat dissipation. The first electrode of the first diode chip and the first electrode of the second diode chip are both soldered to a surface of the substrate. The second electrode of the first diode chip is electrically connected to the first pin. The second electrode of the second diode chip is electrically connected to the second pin. The first pin and the second pin may play a role of signal connection. The packaging structure may be electrically connected to another component through the first pin and the second pin. During specific implementation, one portion of the first pin is wrapped by the plastic packaging body, and the other portion is exposed outside the plastic packaging body; and one portion of the second pin is wrapped by the plastic packaging body, and the other portion is exposed outside the plastic packaging body. For example, when the first pin and the second pin are in a long strip shape, the plastic packaging body may wrap most of the first pin and the second pin, to expose ends of the first pin and the second pin, so that the packaging structure may be electrically connected to another component through the first pin and the second pin. Certainly, in some cases, the plastic packaging body may fully wrap the first pin and the second pin, and the first pin and the second pin may be led out by using other connecting parts.

In a possible implementation, the packaging structure in this embodiment of this application may further include a second bonding member and a third bonding member, and the plastic packaging body wraps the second bonding member and the third bonding member. The second electrode of the first diode chip is bonded to the first pin through the second bonding member, and the second electrode of the second diode chip is bonded to the second pin through the third bonding member. During specific implementation, widths of the first bonding member, the second bonding member, and the third bonding member may be basically the same. For example, the first bonding member, the second bonding member, and the third bonding member may all be bonding wires. In a manufacturing process, the first bonding wire, the second bonding wire, and the third bonding wire may be manufactured by using a high-purity metal bonding wire. For example, a bonding wire of a metal material such as copper, aluminum, gold, or silver may be used. Certainly, in some cases, the first bonding wire, the second bonding wire, and the third bonding wire may alternatively be manufactured by using another electrically conductive material. In a manufacturing process, the first bonding wire may be manufactured by using a wire bonding process. To improve manufacturing efficiency, the first bonding wire, the second bonding wire, and the third bonding wire may be manufactured by using a same bonding process.

In another possible implementation, a width of the first bonding member may be greater than widths of the second bonding member and the third bonding member. For example, the first bonding member may be a strip structure, for example, may be an aluminum ribbon (ribbon), and the second bonding member and the third bonding member may be bonding wires.

Certainly, in some cases, the first bonding member may alternatively be manufactured in another bonding manner. This is not limited herein.

In another possible implementation, the packaging structure in this embodiment of this application may further include a second bonding member, and the plastic packaging body wraps the second bonding member. The first bonding member is bonded to the second electrode of the first diode chip, the second electrode of the second diode chip, and the first pin. The second bonding member is bonded to the second electrode of the first diode chip, the second electrode of the second diode chip, and the second pin. During specific implementation, when the second electrodes of the first diode chip and the second diode chip are both located on the upper surfaces, the first bonding member may be lapped to the upper surfaces of the first diode chip, the second diode chip, and the first pin, and the second bonding member may be lapped to the upper surfaces of the first diode chip, the second diode chip, and the second pin.

The first bonding member may be an integrated structure in a fold-line shape, and the first bonding member may be bent on the upper surface of the first diode chip. The second bonding member may be an integrated structure in a fold-line shape, and the second bonding member may be bent on the upper surface of the second diode chip. In a manufacturing process, the first bonding member may be manufactured by using a bonding process. In the bonding process, three solder joints (a first solder joint, a second solder joint, and a third solder joint respectively) may be disposed. The first solder joint may be located on the upper surface of the second diode chip, the second solder joint may be located on the upper surface of the first diode chip, and the third solder joint may be located on the upper surface of the first pin. The first bonding member may be bent at the second solder joint, but the first bonding member is not broken, so that the same first bonding member is lapped to the upper surfaces of the first diode chip, the second diode chip, and the first pin, thereby obtaining the integrated first bonding member in the fold-line shape. Similarly, the second bonding member may be manufactured in a similar manner, and details are not described herein.

In another possible implementation, the first bonding member may be bonded to the second electrode of the first diode chip, the second electrode of the second diode chip, the first pin, and the second pin. The first bonding member may be an integrated structure in a fold-line shape, and the first bonding member may be bent on the upper surface of the first diode chip and the upper surface of the second diode chip. During specific implementation, when the second electrodes of the first diode chip and the second diode chip are both located on the upper surfaces, the first bonding member may be lapped to the upper surfaces of the first diode chip, the second diode chip, the first pin, and the second pin. For example, the first bonding member may be a sheet structure, and the manufactured first bonding member in the fold-line shape may be bonded to the upper surfaces of the first diode chip, the second diode chip, the first pin, and the second pin. Alternatively, the first bonding member may be a bonding wire. In a bonding process, four solder joints may be disposed on the surfaces of the first diode chip, the second diode chip, the first pin, and the second pin respectively, and the bonding wire is bent at the second solder joint and the third solder joint, but the bonding wire is not broken, so that the same bonding wire is lapped to the upper surfaces of the first diode chip, the second diode chip, the first pin, and the second pin, thereby obtaining the integrated first bonding member in the fold-line shape.

In some other embodiments of this application, the second electrodes of the first diode chip and the second diode chip may be electrically connected to a same pin. The lead frame may include: a substrate and a first pin that are disposed separately. The first electrode of the first diode chip and the first electrode of the second diode chip are both soldered to a surface of the substrate, and the substrate may perform functions such as support and heat dissipation. The second electrode of the first diode chip and the second electrode of the second diode chip are both electrically connected to the first pin. The first pin may play a role of signal connection, and the packaging structure may be electrically connected to another component through the first pin. During specific implementation, one portion of the first pin is wrapped by the plastic packaging body, and the other portion is exposed outside the plastic packaging body. For example, when the first pin is in a long strip shape, the plastic packaging body may wrap most of the first pin, to expose an end of the first pin, so that the packaging structure may be electrically connected to another component through the first pin. Certainly, in some cases, the plastic packaging body may fully wrap the first pin, and the first pin may be led out by using another connecting part.

In a possible implementation, the packaging structure in this embodiment of this application may further include a second bonding member and a third bonding member, and the plastic packaging body wraps the second bonding member and the third bonding member. The second electrode of the first diode chip is bonded to the first pin through the second bonding member, and the second electrode of the second diode chip is bonded to the first pin through the third bonding member. During specific implementation, widths of the first bonding member, the second bonding member, and the third bonding member may be basically the same. For example, the first bonding member, the second bonding member, and the third bonding member may all be bonding wires. In a manufacturing process, the first bonding wire, the second bonding wire, and the third bonding wire may be manufactured by using a high-purity metal bonding wire. For example, a bonding wire of a metal material such as copper, aluminum, gold, or silver may be used. Certainly, in some cases, the first bonding wire, the second bonding wire, and the third bonding wire may alternatively be manufactured by using another electrically conductive material. In a manufacturing process, the first bonding wire may be manufactured by using a wire bonding process. To improve manufacturing efficiency, the first bonding wire, the second bonding wire, and the third bonding wire may be manufactured by using a same bonding process. Certainly, in some cases, the first bonding member may alternatively be manufactured in another bonding manner, and a width of the first bonding member may alternatively be greater than or less than a width of the second bonding member (or the third bonding member). This may be set according to an actual requirement, and is not limited herein.

In another possible implementation, the first bonding member is bonded to the second electrode of the first diode chip, the second electrode of the second diode chip, and the first pin, the first bonding member is an integrated structure in a fold-line shape, and the first bonding member may be bent on the upper surface of the first diode chip and the upper surface of the second diode chip. During specific implementation, when the second electrodes of the first diode chip and the second diode chip are both located on the upper surfaces, the first bonding member may be lapped to the upper surfaces of the first diode chip, the second diode chip, and the first pin. For example, the first bonding member may be a sheet structure, and the manufactured first bonding member in the fold-line shape may be bonded to the upper surfaces of the first diode chip, the second diode chip, and the first pin. Alternatively, the first bonding member may be a bonding wire. In a bonding process, one solder joint may be disposed on the surfaces of the first diode chip and the second diode chip separately, two solder joints are disposed on the surface of the first pin, and the bonding wire is bent at the second solder joint and the third solder joint, but the bonding wire is not broken, so that the same bonding wire is lapped to the upper surfaces of the first diode chip, the second diode chip, and the first pin, thereby obtaining the integrated first bonding member in the fold-line shape.

The foregoing describes several manners in which an electrical connection between the second electrodes of the first diode chip and the second diode chip is implemented through the first bonding member. During specific implementation, each connecting part in the packaging structure may alternatively be implemented in another manner, and no examples are provided one by one herein.

According to a second aspect, an embodiment of this application further provides a power conversion apparatus. The power conversion apparatus in this embodiment of this application may be an apparatus such as a charging pile, a residential photovoltaic device, a power plant, an energy storage device, or an inverter. The power conversion apparatus in this embodiment of this application may include any one of the packaging structures in the first aspect and a switch device. Because a first bonding member is disposed in the foregoing packaging structure in this embodiment of this application, a second electrode of a first diode chip may be bonded to a second electrode of a second diode chip through the first bonding member. In this way, parasitic inductance between the second electrodes of the first diode chip and the second diode chip can be reduced, thereby suppressing an amplitude of voltage oscillation between the second electrodes of the first diode chip and the second diode chip, and eliminating electromagnetic compatibility oscillation. Therefore, the power conversion apparatus including the foregoing packaging structure does not suffer from interference from electromagnetic compatibility oscillation, and the power conversion apparatus has good performance.

### BRIEF DESCRIPTION OF DRAWINGS

FIG. 1 is a diagram of an equivalent circuit of a common cathode diode;
FIG. 2 is a top view of a structure of a packaging structure according to an embodiment of this application;
FIG. 3 is a diagram of a cross section at a dashed line AA' in FIG. 2;
FIG. 4 is a diagram of an equivalent circuit of the packaging structure shown in FIG. 2;
FIG. 5 is a top view of another structure of a packaging structure according to an embodiment of this application;
FIG. 6 is a top view of still another structure of a packaging structure according to an embodiment of this application;
FIG. 7 is a top view of yet another structure of a packaging structure according to an embodiment of this application;
FIG. 8 is a top view of still yet another structure of a packaging structure according to an embodiment of this application; and
FIG. 9 is a top view of a further structure of a packaging structure according to an embodiment of this application.

### Reference numerals:

11: lead frame; 111: substrate; 112: first pin; 113: second pin; 121: first diode chip; 122: second diode chip; 131: first bonding member; 132: second bonding member; 133: third bonding member; 14: plastic packaging body; Q1: cathode pin; Q2 and Q3: anode pins; L1, L2, and L3: parasitic inductors; C1 and C2: parasitic capacitors; P1: first electrode; P2: second electrode.

### DESCRIPTION OF EMBODIMENTS

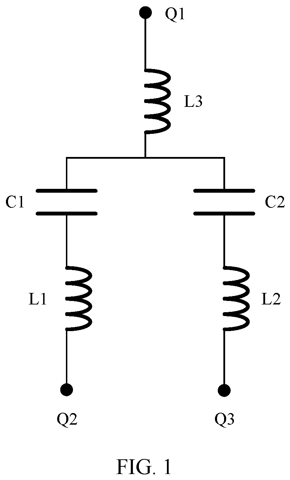

In a related technology, a common cathode diode is a device commonly used in a power conversion apparatus. FIG. 1 is a diagram of an equivalent circuit of a common cathode diode. As shown in FIG. 1, the common cathode diode generally has three pins, which are one cathode pin Q1 and two anode pins Q2 and Q3 respectively. In general, the common cathode diode is electrically connected to a switch device. In an operating process of the power conversion apparatus, the switch device is frequently turned on and off. This causes potentials at two ends of the common cathode diode to jump, leading to the generation of parasitic inductance (for example, L1, L2, and L3 in FIG. 1) and parasitic capacitance (for example, C1 and C2 in FIG. 1) in the common cathode diode. The parasitic inductance of the two anode pins Q2 and Q3 resonates with the parasitic capacitance. Therefore, high-frequency voltage oscillation is generated at the two anode pins Q2 and Q3, to form an interference source, resulting in electromagnetic compatibility (electromagnetic compatibility, EMC) oscillation.

Therefore, to eliminate the problem of electromagnetic compatibility oscillation of the common cathode diode, embodiments of this application provide a packaging structure and a power conversion apparatus. The packaging structure provided in embodiments of this application may be a common cathode diode packaging structure or a common anode diode packaging structure, or the packaging structure provided in embodiments of this application may be another packaging structure including a common cathode (or common anode) diode. This is not limited herein. The packaging structure in embodiments of this application may be applied to a power conversion apparatus such as a charging pile, a residential photovoltaic device, a power plant, an energy storage device, or an inverter. Certainly, in some cases, the packaging structure in embodiments of this application may also be applied to another power conversion apparatus or another electronic device.

To make the objectives, technical solutions, and advantages of this application clearer, the following further describes this application in detail with reference to the accompanying drawings.

It should be noted that same reference numerals in the accompanying drawings of this application indicate same or similar structures. Therefore, repeated descriptions thereof are omitted. Expressions of locations and directions in this application are described by using the accompanying drawings as an example. However, changes may also be made according to a requirement, and all the changes fall within the protection scope of this application. The accompanying drawings in this application are merely used to illustrate relative position relationships and do not represent an actual scale.

In descriptions of this application, it should be noted that orientation or position relationships indicated by terms such as "center", "above", "below", "left", "right", "vertical", "horizontal", "inside", and "outside" are based on the orientation or position relationships shown in the accompanying drawings, and are merely intended for the convenience of describing this application and simplifying descriptions, rather than indicating or implying that an apparatus or element in question needs to have a specific orientation or needs to be constructed and operated in a specific orientation, and therefore cannot be construed as a limitation on this application. In addition, terms "first" and "second" are merely used for a purpose of description, and shall not be understood as an indication or implication of relative importance.

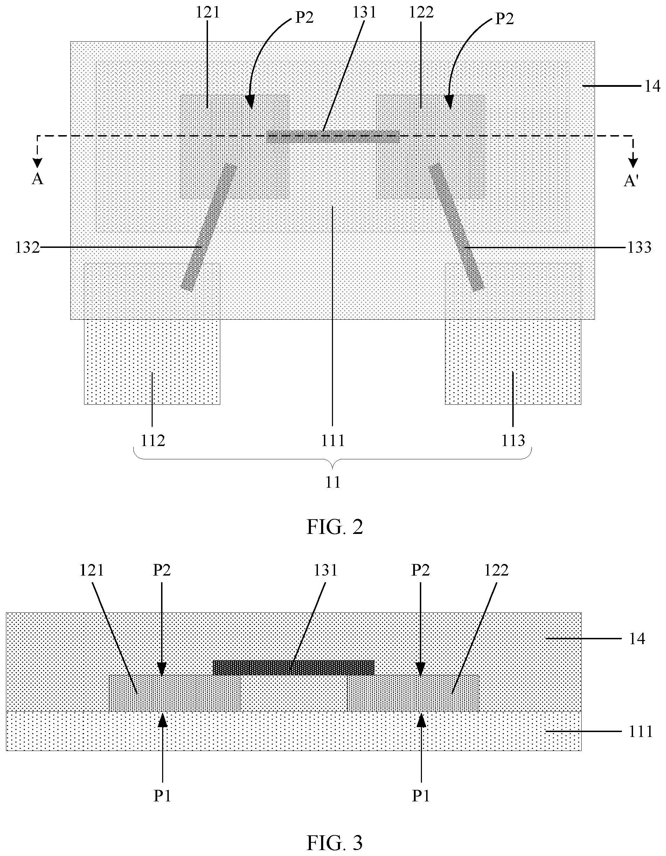

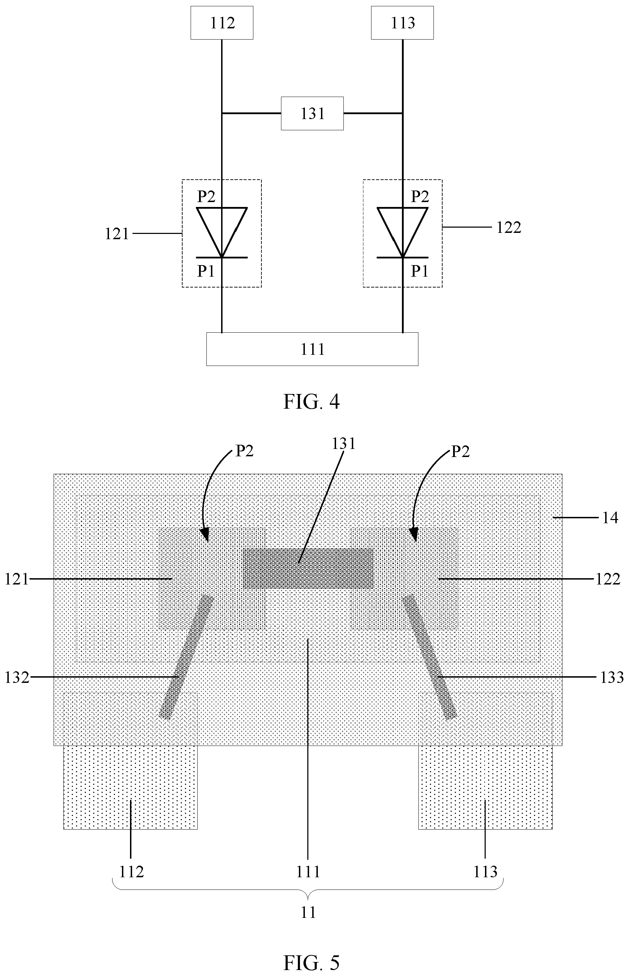

FIG. 2 is a top view of a structure of a packaging structure according to an embodiment of this application. FIG. 3 is a diagram of a cross section at a dashed line AA' in FIG. 2. FIG. 4 is a diagram of an equivalent circuit of the packaging structure shown in FIG. 2. With reference to FIG. 2 to FIG. 4, the packaging structure provided in embodiments of this application may include a lead frame 11, a first diode chip 121, a second diode chip 122, a first bonding member 131, and a plastic packaging body 14. The first diode chip 121 and the second diode chip 122 are both located on the lead frame 11. The first diode chip 121 and the second diode chip 122 both have a first electrode P1 and a second electrode P2. In embodiments of this application, the first electrode P1 is an anode of the diode chip, and the second electrode P2 is a cathode of the diode chip; or the first electrode P1 is a cathode of the diode chip, and the second electrode P2 is an anode of the diode chip. The first electrode P1 of the first diode chip 121 and the first electrode P1 of the second diode chip 122 are both soldered to a surface of the lead frame 11. The lead frame 11 includes an electrically conductive material. For example, the lead frame 11 may include a metal material such as copper, iron, or aluminum. The first electrode P1 of the first diode chip 121 is electrically connected to the first electrode P1 of the second diode chip 122 through the lead frame 11. The second electrode P2 of the first diode chip 121 is bonded to the second electrode P2 of the second diode chip 122 through the first bonding member 131. The plastic packaging body 14 wraps the first diode chip 121, the second diode chip 122, and the first bonding member 131.

In the packaging structure provided in embodiments of this application, the first electrode P1 of the first diode chip 121 is electrically connected to the first electrode P1 of the second diode chip 122 through the lead frame 11, and the first electrode P1 may be a cathode or an anode of a diode. Therefore, the packaging structure provided in embodiments of this application may be a common cathode diode packaging structure, or may be a common anode diode packaging structure. In embodiments of this application, the first bonding member 131 is disposed in the packaging structure, so that the second electrode P2 of the first diode chip 121 may be bonded to the second electrode P2 of the second diode chip 122 through the first bonding member 131. In this way, parasitic inductance between the second electrodes P2 of the first diode chip 121 and the second diode chip 122 can be reduced, thereby suppressing an amplitude of voltage oscillation between the second electrodes P2 of the first diode chip 121 and the second diode chip 122, and eliminating electromagnetic compatibility oscillation. In addition, the second electrode P2 of the first diode chip 121 is bonded to the second electrode P2 of the second diode chip 122 through the first bonding member 131. This does not affect a connection relationship between the first diode chip 121 or the second diode chip 122 and another component, and does not affect overall performance of the packaging structure.

In addition, the plastic packaging body 14 wraps the first diode chip 121, the second diode chip 122, and the first bonding member 131, and the packaging body 14 may play a function of protecting and fastening various components. The first bonding member 131 is packaged inside the plastic packaging body 14, so that the first bonding member 131 is not exposed outside the packaging structure, and no electrical safety or reliability problem is caused, thereby ensuring high security and reliability of the packaging structure. The first bonding member 131 in embodiments of this application may be a bonding wire, a strip structure, a sheet structure, or the like. For example, the strip structure may be an aluminum ribbon (ribbon), and the sheet structure may be a copper clip (clip). For example, the first bonding member 131 may include a metal material such as copper, aluminum, gold, or silver, or the first bonding member 131 may include another electrically conductive material. In a manufacturing process, the first bonding member 131 may be manufactured by using a bonding process or another process, which is easily compatible with a manufacturing process of another component in the packaging structure. For example, the first bonding wire 131 may be manufactured in a wire bonding (wire bonding) process of a packaging front-of-line (front-of-line, FOL) process. The manufacturing process is feasible and stable, with low manufacturing costs, high manufacturability, and high supply availability.

In embodiments of this application, the first diode chip 121 and the second diode chip 122 are disposed in the packaging structure, and the first diode chip 121 and the second diode chip 122 are disposed in parallel. In other words, two diode chips in parallel are disposed in the packaging structure. During specific implementation, more diode chips in parallel may be disposed in the packaging structure. Alternatively, another electronic component may be disposed in the packaging structure according to an actual requirement. The packaging structure in embodiments of this application may use a transistor outline (transistor outline, TO), or the packaging structure may be in another packaging form.

As shown in FIG. 2 and FIG. 3, in embodiments of this application, the first electrode P1 of the first diode chip 121 may be located on a lower surface of the first diode chip 121, and the second electrode P2 of the first diode chip 121 may be located on an upper surface of the first diode chip 121. The first electrode P1 of the second diode chip 122 may be located on a lower surface of the second diode chip 122, and the second electrode P2 of the second diode chip 122 may be located on an upper surface of the second diode chip 122. The upper surface of the first diode chip 121 (or the second diode chip 122) is a surface on a side that is of the first diode chip 121 (or the second diode chip 122) and that faces away from the lead frame 11, and the lower surface is a surface on a side that is of the first diode chip 121 (or the second diode chip 122) and that is close to the lead frame 11. In other words, descriptions of the "upper surface" and the "lower surface" herein are consistent with directions in a view shown in FIG. 3. In embodiments of this application, the first electrode P1 and the second electrode P2 of the first diode chip 121 (or the second diode chip 122) are disposed on the lower surface and the upper surface respectively, to facilitate an electrical connection to another component. In addition, the first electrodes P1 of the first diode chip 121 and the second diode chip 122 are located on surfaces on a same side, and the second electrodes P2 are located on surfaces on a same side, to facilitate an electrical connection between the first electrodes P1 of the first diode chip 121 and the second diode chip 122 and an electrical connection between the second electrodes P2 of the first diode chip 121 and the second diode chip 122. Because the lead frame 11 in embodiments of this application includes the electrically conductive material, when the first diode chip 121 and the second diode chip 122 are installed at corresponding positions on the surface of the lead frame 11, an electrical connection between the first electrodes P1 of the first diode chip 121 and the second diode chip 122 can be implemented. The first bonding member 131 is lapped to the upper surfaces of the first diode chip 121 and the second diode chip 122, so that an electrical connection between the second electrodes P2 of the first diode chip 121 and the second diode chip 122 can be implemented through the first bonding member 131.

Certainly, in some cases, the first electrode P1 and the second electrode P2 of the first diode chip 121 (or the second diode chip 122) may alternatively be disposed on a surface on a same side. For example, the first electrode P1 and the second electrode P2 of the first diode chip 121 (or the second diode chip 122) may be disposed at different positions on the upper surface, and can also implement an electrical connection to another component, and may be disposed based on a spatial layout of the packaging structure.

In some embodiments of this application, the second electrodes of the first diode chip and the second diode chip may be electrically connected to different pins respectively. As shown in FIG. 2 and FIG. 3, the lead frame 11 may include: a substrate 111, a first pin 112, and a second pin 113 that are disposed separately. The first diode chip 121 and the second diode chip 122 are located on the substrate 111, and the substrate 111 may perform functions such as support and heat dissipation. The first electrode P1 of the first diode chip 121 and the first electrode P1 of the second diode chip 122 are both soldered to a surface of the substrate 111. The second electrode P2 of the first diode chip 121 is electrically connected to the first pin 112. The second electrode P2 of the second diode chip 122 is electrically connected to the second pin 113. The first pin 112 and the second pin 113 may play a role of signal connection. The packaging structure may be electrically connected to another component through the first pin 112 and the second pin 113. During specific implementation, one portion of the first pin 112 is wrapped by the plastic packaging body 14, and the other portion is exposed outside the plastic packaging body 14; and one portion of the second pin 113 is wrapped by the plastic packaging body 14, and the other portion is exposed outside the plastic packaging body 14. For example, when the first pin 112 and the second pin 113 are in a long strip shape, the plastic packaging body 14 may wrap most of the first pin 112 and the second pin 113, to expose ends of the first pin 112 and the second pin 113, so that the packaging structure may be electrically connected to another component through the first pin 112 and the second pin 113. Certainly, in some cases, the plastic packaging body 14 may fully wrap the first pin 112 and the second pin 113, and the first pin 112 and the second pin 113 may be led out by using other connecting parts.

In a possible implementation, as shown in FIG. 2, the packaging structure in embodiments of this application may further include a second bonding member 132 and a third bonding member 133, and the plastic packaging body 14 wraps the second bonding member 132 and the third bonding member 133. The second electrode P2 of the first diode chip 121 is bonded to the first pin 112 through the second bonding member 132, and the second electrode P2 of the second diode chip 122 is bonded to the second pin 113 through the third bonding member 133. During specific implementation, widths of the first bonding member 131, the second bonding member 132, and the third bonding member 133 may be basically the same. For example, the first bonding member 131, the second bonding member 132, and the third bonding member 133 may all be bonding wires. In a manufacturing process, the first bonding wire 131, the second bonding wire 132, and the third bonding wire 133 may be manufactured by using a high-purity metal bonding wire. For example, a bonding wire of a metal material such as copper, aluminum, gold, or silver may be used. Certainly, in some cases, the first bonding wire 131, the second bonding wire 132, and the third bonding wire 133 may alternatively be manufactured by using another electrically conductive material. In a manufacturing process, the first bonding wire 131 may be manufactured by using a wire bonding process. To improve manufacturing efficiency, the first bonding wire 131, the second bonding wire 132, and the third bonding wire 133 may be manufactured by using a same bonding process.

FIG. 5 is a top view of another structure of a packaging structure according to an embodiment of this application. As shown in FIG. 5, a width of the first bonding member 131 may be greater than widths of the second bonding member 132 and the third bonding member 133. For example, the first bonding member 131 may be a strip structure, for example, may be an aluminum ribbon (ribbon), and the second bonding member 132 and the third bonding member 133 may be bonding wires.

Certainly, in some cases, the first bonding member 131 may be manufactured in another bonding manner. This is not limited herein.

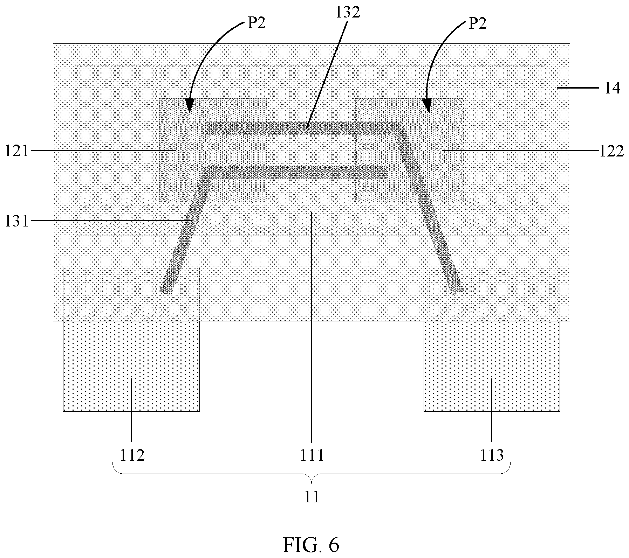

In another possible implementation, as shown in FIG. 6, FIG. 6 is a top view of still another structure of a packaging structure according to an embodiment of this application. The packaging structure in embodiments of this application may further include a second bonding member 132, and the plastic packaging body 14 wraps the second bonding member 132. The first bonding member 131 is bonded to the second electrode P2 of the first diode chip 121, the second electrode P2 of the second diode chip 122, and the first pin 112. The second bonding member 132 is bonded to the second electrode P2 of the first diode chip 121, the second electrode P2 of the second diode chip 122, and the second pin 113. During specific implementation, when the second electrodes P2 of the first diode chip 121 and the second diode chip 122 are both located on the upper surfaces, the first bonding member 131 may be lapped to the upper surfaces of the first diode chip 121, the second diode chip 122, and the first pin 112, and the second bonding member 132 may be lapped to the upper surfaces of the first diode chip 121, the second diode chip 122, and the second pin 113.

As shown in FIG. 6 again, the first bonding member 131 may be an integrated structure in a fold-line shape, and the first bonding member 131 may be bent on the upper surface of the first diode chip 121. The second bonding member 132 may be an integrated structure in a fold-line shape, and the second bonding member 132 may be bent on the upper surface of the second diode chip 122. In a manufacturing process, the first bonding member 131 may be manufactured by using a bonding process. In the bonding process, three solder joints (a first solder joint, a second solder joint, and a third solder joint respectively) may be disposed. The first solder joint may be located on the upper surface of the second diode chip 122, the second solder joint may be located on the upper surface of the first diode chip 121, and the third solder joint may be located on the upper surface of the first pin 112. The first bonding member 131 may be bent at the second solder joint, but the first bonding member 131 is not broken, so that the same first bonding member 131 is lapped to the upper surfaces of the first diode chip 121, the second diode chip 122, and the first pin 112, thereby obtaining the integrated first bonding member 131 in the fold-line shape. Similarly, the second bonding member 132 may be manufactured in a similar manner, and details are not described herein.

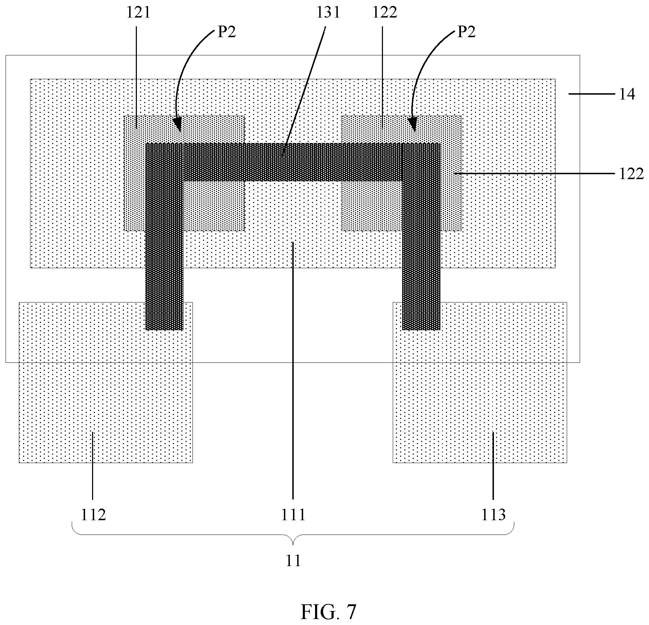

In another possible implementation, as shown in FIG. 7, FIG. 7 is a top view of yet another structure of a packaging structure according to an embodiment of this application. The first bonding member 131 may be bonded to the second electrode P2 of the first diode chip 121, the second electrode P2 of the second diode chip 122, the first pin 112, and the second pin 113. The first bonding member 131 may be an integrated structure in a fold-line shape, and the first bonding member 131 may be bent on the upper surface of the first diode chip 121 and the upper surface of the second diode chip 122. During specific implementation, when the second electrodes P2 of the first diode chip 121 and the second diode chip 122 are both located on the upper surfaces, the first bonding member 131 may be lapped to the upper surfaces of the first diode chip 121, the second diode chip 122, the first pin 112, and the second pin 113. For example, the first bonding member 131 may be a sheet structure, and the manufactured first bonding member 131 in the fold-line shape may be bonded to the upper surfaces of the first diode chip 121, the second diode chip 122, the first pin 112, and the second pin 113. Alternatively, the first bonding member 131 may be a bonding wire. In a bonding process, four solder joints may be disposed on the surfaces of the first diode chip 121, the second diode chip 122, the first pin 112, and the second pin 113 respectively, and the bonding wire is bent at the second solder joint and the third solder joint, but the bonding wire is not broken, so that the same bonding wire is lapped to the upper surfaces of the first diode chip 121, the second diode chip 122, the first pin 112, and the second pin 113, thereby obtaining the integrated first bonding member 131 in the fold-line shape.

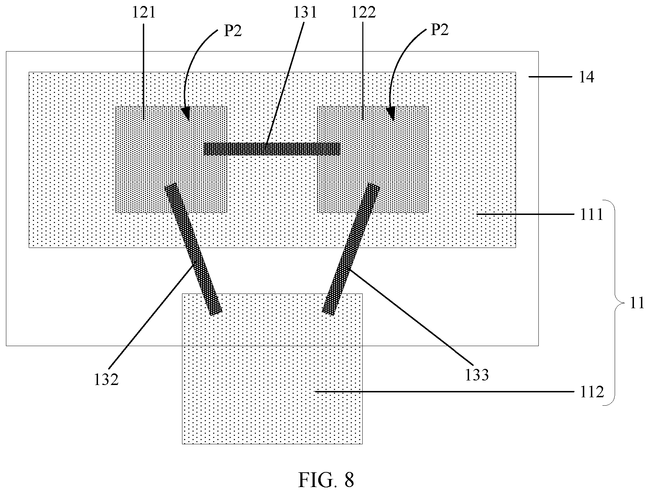

In some other embodiments of this application, the second electrodes of the first diode chip and the second diode chip may be electrically connected to a same pin. FIG. 8 is a top view of still yet another structure of a packaging structure according to an embodiment of this application. As shown in FIG. 8, the lead frame 11 may include a substrate 111 and a first pin 112 that are disposed separately. The first electrode P1 of the first diode chip 121 and the first electrode P1 of the second diode chip 122 are both soldered to a surface of the substrate 111. The substrate 111 may perform functions such as support and heat dissipation. The second electrode P2 of the first diode chip 121 and the second electrode P2 of the second diode chip 122 are both electrically connected to the first pin 112. The first pin 112 may play a role of signal connection, and the packaging structure may be electrically connected to another component through the first pin 112. During specific implementation, one portion of the first pin 112 is wrapped by the plastic packaging body 14, and the other portion is exposed outside the plastic packaging body 14. For example, when the first pin 112 is in a long strip shape, the plastic packaging body 14 may wrap most of the first pin 112, to expose an end of the first pin 112, so that the packaging structure may be electrically connected to another component through the first pin 112. Certainly, in some cases, the plastic packaging body 14 may fully wrap the first pin 112, and the first pin 112 may be led out by using another connecting part.

In a possible implementation, as shown in FIG. 8, the packaging structure in embodiments of this application may further include a second bonding member 132 and a third bonding member 133, and the plastic packaging body 14 wraps the second bonding member 132 and the third bonding member 133. The second electrode P2 of the first diode chip 121 is bonded to the first pin 112 through the second bonding member 132, and the second electrode P2 of the second diode chip 122 is bonded to the first pin 112 through the third bonding member 133. During specific implementation, widths of the first bonding member 131, the second bonding member 132, and the third bonding member 133 may be basically the same. For example, the first bonding member 131, the second bonding member 132, and the third bonding member 133 may all be bonding wires. In a manufacturing process, the first bonding wire 131, the second bonding wire 132, and the third bonding wire 133 may be manufactured by using a high-purity metal bonding wire. For example, a bonding wire of a metal material such as copper, aluminum, gold, or silver may be used. Certainly, in some cases, the first bonding wire 131, the second bonding wire 132, and the third bonding wire 133 may alternatively be manufactured by using another electrically conductive material. In a manufacturing process, the first bonding wire 131 may be manufactured by using a wire bonding process. To improve manufacturing efficiency, the first bonding wire 131, the second bonding wire 132, and the third bonding wire 133 may be manufactured by using a same bonding process. Certainly, in some cases, the first bonding member 131 may alternatively be manufactured in another bonding manner, and a width of the first bonding member 131 may alternatively be greater than or less than a width of the second bonding member 132 (or the third bonding member 133). This may be set according to an actual requirement, and is not limited herein.

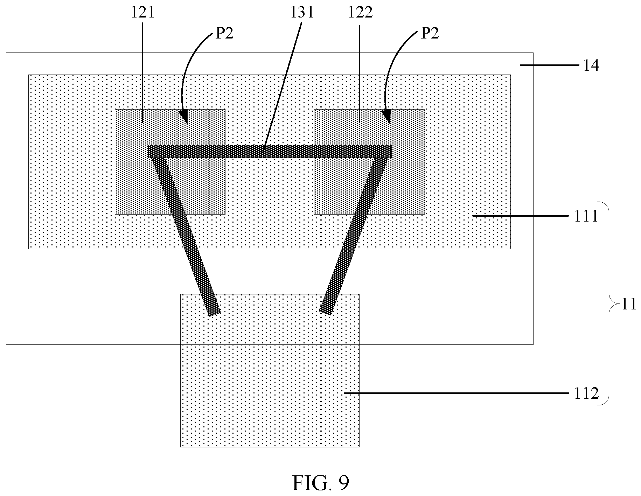

In another possible implementation, as shown in FIG. 9, FIG. 9 is a top view of a further structure of a packaging structure according to an embodiment of this application. The first bonding member 131 is bonded to the second electrode P2 of the first diode chip 121, the second electrode P2 of the second diode chip 122, and the first pin 112. The first bonding member 131 is an integrated structure in a fold-line shape, and the first bonding member 131 may be bent on the upper surface of the first diode chip 121 and the upper surface of the second diode chip 122 separately. During specific implementation, when the second electrodes P2 of the first diode chip 121 and the second diode chip 122 are both located on the upper surfaces, the first bonding member 131 may be lapped to the upper surfaces of the first diode chip 121, the second diode chip 122, and the first pin 112. For example, the first bonding member 131 may be a sheet structure, and the manufactured first bonding member 131 in the fold-line shape may be bonded to the upper surfaces of the first diode chip 121, the second diode chip 122, and the first pin 112. Alternatively, the first bonding member 131 may be a bonding wire. In a bonding process, one solder joint may be disposed on the surfaces of the first diode chip 121 and the second diode chip 122 separately, two solder joints are disposed on the surface of the first pin 112, and the bonding wire is bent at the second solder joint and the third solder joint, but the bonding wire is not broken, so that the same bonding wire is lapped to the upper surfaces of the first diode chip 121, the second diode chip 122, and the first pin 112, thereby obtaining the integrated first bonding member 131 in the fold-line shape.

The foregoing describes, with reference to the accompanying drawings, several manners in which an electrical connection between the second electrodes of the first diode chip and the second diode chip is implemented through the first bonding member. During specific implementation, each connecting part in the packaging structure may alternatively be implemented in another manner, and no examples are provided one by one herein.

Based on a same technical concept, an embodiment of this application further provides a power conversion apparatus. The power conversion apparatus in this embodiment of this application may be an apparatus such as a charging pile, a residential photovoltaic device, a power plant, an energy storage device, or an inverter. The power conversion apparatus in this embodiment of this application may include any one of the foregoing packaging structures and a switch device. Because a first bonding member is disposed in the foregoing packaging structure in this embodiment of this application, a second electrode of a first diode chip may be bonded to a second electrode of a second diode chip through the first bonding member. In this way, parasitic inductance between the second electrodes of the first diode chip and the second diode chip can be reduced, thereby suppressing an amplitude of voltage oscillation between the second electrodes of the first diode chip and the second diode chip, and eliminating electromagnetic compatibility oscillation. Therefore, the power conversion apparatus including the foregoing packaging structure does not suffer from interference from electromagnetic compatibility oscillation, and the power conversion apparatus has good performance.

Although preferred embodiments of this application are described, persons skilled in the art may make changes and modifications to these embodiments after they learn of a basic inventive concept. Therefore, the following claims are intended to be construed as to cover the preferred embodiments and all changes and modifications falling within the scope of this application.

Clearly, persons skilled in the art may make various modifications and variations to embodiments of this application without departing from the spirit and scope of embodiments of this application. This application is intended to cover the modifications and variations of embodiments of this application provided that these modifications and variations fall within the scope defined by the claims of this application and their equivalent technologies.

## Claims

1. A packaging structure, comprising:
a lead frame, wherein the lead frame comprises an electrically conductive material;
a first diode chip and a second diode chip, wherein the first diode chip and the second diode chip both have a first electrode and a second electrode, the first electrode of the first diode chip and the first electrode of the second diode chip are both soldered to a surface of the lead frame, and the first electrode of the first diode chip is electrically connected to the first electrode of the second diode chip through the lead frame;
a first bonding member, wherein the second electrode of the first diode chip is bonded to the second electrode of the second diode chip through the first bonding member; and
a plastic packaging body, wherein the plastic packaging body wraps the first diode chip, the second diode chip, and the first bonding member.

2. The packaging structure according to claim 1, wherein the lead frame comprises: a substrate, a first pin, and a second pin that are disposed separately;
the first electrode of the first diode chip is located on a lower surface of the first diode chip, and the second electrode of the first diode chip is located on an upper surface of the first diode chip;
the first electrode of the second diode chip is located on a lower surface of the second diode chip, and the second electrode of the second diode chip is located on an upper surface of the second diode chip;
the first electrode of the first diode chip and the first electrode of the second diode chip are both soldered to a surface of the substrate;
the second electrode of the first diode chip is electrically connected to the first pin, and the second electrode of the second diode chip is electrically connected to the second pin;
one portion of the first pin is wrapped by the plastic packaging body, and the other portion is exposed outside the plastic packaging body; and
one portion of the second pin is wrapped by the plastic packaging body, and the other portion is exposed outside the plastic packaging body.

3. The packaging structure according to claim 2, wherein the first bonding member is bonded to the second electrode of the first diode chip, the second electrode of the second diode chip, the first pin, and the second pin; and
the first bonding member is in a fold-line shape, and the first bonding member is bent on the upper surface of the first diode chip and the upper surface of the second diode chip separately.

4. The packaging structure according to claim 2, further comprising: a second bonding member, wherein the plastic packaging body wraps the second bonding member;
the first bonding member is bonded to the second electrode of the first diode chip, the second electrode of the second diode chip, and the first pin; and
the second bonding member is electrically connected to and bonded to the second electrode of the first diode chip, the second electrode of the second diode chip, and the second pin.

5. The packaging structure according to claim 4, wherein the first bonding member is in a fold-line shape, the first bonding member is bent on the upper surface of the first diode chip, the second bonding member is in a fold-line shape, and the second bonding member is bent on the upper surface of the second diode chip.

6. The packaging structure according to claim 2, further comprising: a second bonding member and a third bonding member, wherein the plastic packaging body wraps the second bonding member and the third bonding member; and
the second electrode of the first diode chip is bonded to the first pin through the second bonding member, and the second electrode of the second diode chip is bonded to the second pin through the third bonding member.

7. The packaging structure according to claim 1, wherein the lead frame comprises: a substrate and a first pin that are disposed separately;
the first electrode of the first diode chip is located on a lower surface of the first diode chip, and the second electrode of the first diode chip is located on an upper surface of the first diode chip;
the first electrode of the second diode chip is located on a lower surface of the second diode chip, and the second electrode of the second diode chip is located on an upper surface of the second diode chip;
the first electrode of the first diode chip and the first electrode of the second diode chip are both soldered to a surface of the substrate;
the second electrode of the first diode chip and the second electrode of the second diode chip are both electrically connected to the first pin; and
one portion of the first pin is wrapped by the plastic packaging body, and the other portion is exposed outside the plastic packaging body.

8. The packaging structure according to claim 7, wherein the first bonding member is bonded to the second electrode of the first diode chip, the second electrode of the second diode chip, and the first pin, the first bonding member is in a fold-line shape, and the first bonding member is bent on the upper surface of the first diode chip and the upper surface of the second diode chip separately.

9. The packaging structure according to any one of claims 1 to 8, wherein the first bonding wire is a bonding wire, a strip structure, or a sheet structure.

10. A power conversion apparatus, comprising the packaging structure according to any one of claims 1 to 9 and a switch device.
